(19) Europäisches Patentamt
European Patent Office
Office européen des brevets

(11) **EP 0 920 026 A1**

(12) **EUROPEAN PATENT APPLICATION**

(43) Date of publication:
02.06.1999 Bulletin 1999/22

(51) Int. Cl.⁶: **G11C 11/41**

(21) Application number: 97120942.4

(22) Date of filing: 28.11.1997

(84) Designated Contracting States:
AT BE CH DE DK ES FI FR GB GR IE IT LI LU MC NL PT SE
Designated Extension States:
AL LT LV MK RO SI

(71) Applicant:
STMicroelectronics S.r.l.
20041 Agrate Brianza (Milano) (IT)

(72) Inventor: **Tooher, Michael**
DE-70193 Stuttgart (DE)

(74) Representative: **Botti, Mario**
Botti & Ferrari S.r.l.
Via Locatelli, 5
20124 Milano (IT)

(54) **A low power RAM memory cell with a single bit line**

(57) The invention relates to a RAM memory cell (10) with a single bit line for a memory matrix comprising a plurality of word-lines (WL) and bit-lines (BL), such a cell (10) including a first and a second cross-coupled CMOS inverters (12, 13), each including a PMOS pull-up transistor (M3, M4) and an NMOS pull-down transistor (M1, M2), and an access transistor (M5) connecting one of the inverter (13) to the bit line (BL). An extra transistor (M6) is provided to connect the source terminal of one of the pull-down transistors (M1, M2) to a ground (GND).

More specifically, the extra transistor (M6) is connected between the source terminal of the pull-down transistor (M1) of the first inverter (12) and said ground (GND) and the gate terminal of the extra transistor (M6) is connected to a signal line (WE) running parallel to the word line.

Fig. 3

## Description

### Background of the invention

The present invention relates to a low power RAM memory cell with a single bit line for a memory matrix comprising a plurality of word-lines and bit-lines, said cell including a first and a second cross-coupled CMOS inverters, each including a PMOS pull-up transistor and an NMOS pull-down transistor, and an access transistor connecting one of the inverter to the bit line.

The invention relates to integrated memory circuits and more specifically, but not exclusively, to integrated static random access memories.

As is well known, an electronic random access memory device includes a plurality of basic memory cells each comprising six transistors.

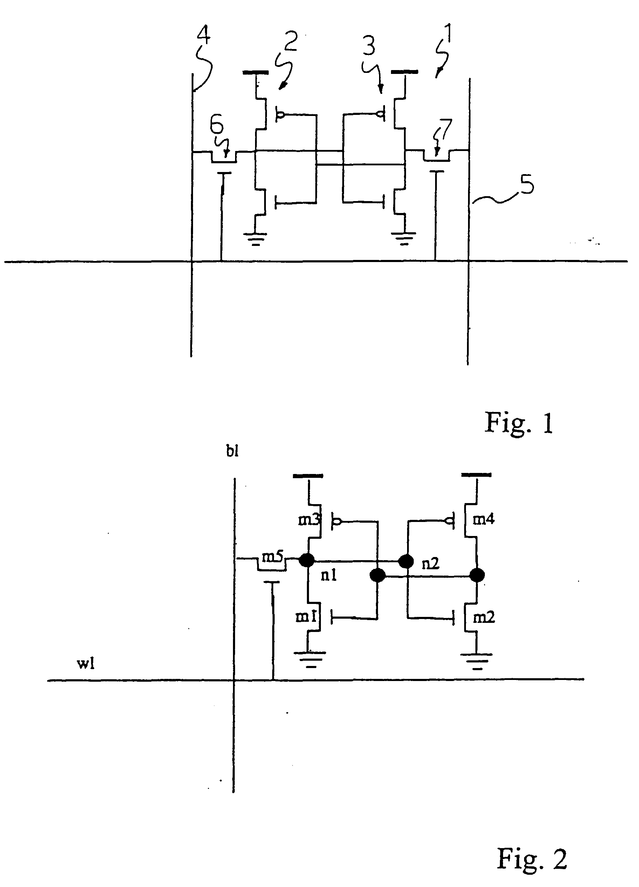

The enclosed figure 1 shows an example of a basic six transistors memory cell which is realized by CMOS technology. The cell 1 shown in figure 1 includes a pair of cross-coupled CMOS inverters 2 and 3 each of which is coupled to a corresponding bit line 4, 5 of the memory device. The first inverter 2 is coupled to the bit line 4 through a bi-directional access devices 6 while the second inverter 3 is coupled to the adjacent bit line 5 through a second bi-directional access devices 7.

During the reading and writing phases of the memory cell, a differential voltage must be applied between the bit lines 4, 5. In this respect, we might consider the cell access to the storage node as "differential".

In the reading phase, the bit line swing amplitude depends on how long the cells have been activated. The voltage difference due to the swing can be kept quite small and can be sensed by the sense amplifier of the memory device. This helps to reduce power consumption.

In the writing phase, the bit line voltage swing should be as large as possible, even a full CMOS level, in order to toggle the cells.

If we consider a RAM memory array or matrix having m rows and n columns, and including six transistors cells, the current consumption can be easily estimated using the following formulas:

$$Iddr = n * m * Cb * \Delta Vr * P \qquad (1)$$

for the reading phase, and

$$Iddw = n * m * Cb * \Delta Vw * P \qquad (2)$$

for the writing phase;
where: Cb is the bit line capacitance associated to a given cell; $\Delta Vr$ is the read voltage bit line swing and $\Delta Vw$ is the write voltage bit line swing; P is the probability of a bitline switching during an operation. Usually $\Delta Vw$ corresponds to the supply voltage value Vdd.

Some prior art techniques are used to reduce the power dissipation of the memory matrix. Those techniques try to intervene on one or more of the parameters contained in the above formulas.

For instance, a first prior art solution is disclosed in: N. Kushiyama et al. "A 295 Mhz CMOS 1M (x256) embedded SRAM using I-directional read/write shared sense amplifiers and self-timed pulsed word-line drivers", ISSCC Dig. Tech. Papers Feb. 1995, pp. 182-183.

This solution proposes to reduce power dissipation by reducing the number of cells hung on the bit line using a hierarchical bit line scheme.

A second prior art solution is disclosed in: B. Amrutur and H. Horowitz "Technique to reduce power in fast wide memories" Dig. Tech. Papers, Oct. 1994, Symp. on Low Power Electronics, pp 92-93.

This second solution proposes to reduce power dissipation limiting the read bit line swing by controlling the word line pulse length.

A third prior art solution is disclosed in: T. Blalock and R. Jager " A high-speed clamped bit line current-mode sense amplifiers" IEEE J. Solid State Circuits, vol. 26, No. 4, pp. 542-548, April 1991.

Even this solution proposes to reduce power dissipation limiting the read bit line swing, but using current-mode sense amplifiers; thus reducing $\Delta Vr$.

A further known solution proposes to limit the write bit line swing to a predetermined value, namely Vdd-Vt, using a NMOS transistors precharge phase.

Also a reduction of the probability P of a bit line switching during an operation would reduce the current consumption. Just in this respect, the present invention works on the principle of reducing the probability P of a bit line switching.

Some attempts have already been performed to reduce the current consumption by providing a single bit line per memory cell rather than a bit line pair.

For instance: the article by M. Ukita et al., " A single-bit-line cross-point cell activation (SCPA) architecture for ultra-low-power SRAMs", IEEE J. Solid State Circuits, vol. 28, No, 11, pp. 1114-1118, November 1993, relates to a single bit line architecture including RAM cells with five transistors and a single bit line, as shown in Figure 2.

Moreover, another article by K.J. O'Connor, "A source sensing technique applied to SRAM cells", IEEE J. Solid State Circuits, vol. 30, No, 4, pp. 500-511, April 1995, relates to the problem of writing a single access RAM cell.

As a matter of fact, during the reading phase of a single access memory cell, the probability of switching is dependent on the data stored in the cell. Hence, the power dissipation is statiscally reduced by half.

During the writing phase, the bit lines are discharged only when a logic value "0" must be written. Hence, even in such a case, the probability of switching is statiscally reduced by half.

However, single access memory cells present a serious drawback which comes from the difficulty of writing a logic value "1" into the cells.

The last mentioned known solutions try to solve the problem of writing the logic value "1" into a single access memory cell. However, the proposed solutions require special techniques which are complex and increase also the design complexity of the memory circuit.

One object of the present invention is that of providing a SRAM memory device having a reduced power consumption.

Another object of the present invention is that of achieving a reduction in the probability of a bit line switching by using a single bit line per memory cell.

A further object of the present invention is that of providing a very simple write operation technique.

A further object of the present invention is that of providing an SRAM memory cell having very long wordlenght but a reduced power dissipation.

Summary of the invention

The solution idea behind this invention is that of providing a ground for a pull-down transistor of the cell during the reading phase and turning off the current flow across such a transistor during the writing phase.

According to this solution idea, the technical problem is solved by a RAM memory cell according to the claim 1.

The features and advantages of the RAM memory cell according to the invention will be appreciated by the following description of a preferred embodiment given by way of non-limiting example with reference to the annexed drawings.

Brief description of the drawings

Figure 1 shows a simplified schematic diagram of a conventional and known double bit-line CMOS SRAM memory cell;

Figure 2 shows a simplified schematic diagram of a conventional and known single bit-line CMOS SRAM memory cell;

Figure 3 shows a simplified schematic diagram of a CMOS RAM memory cell according to the present invention;

Figure 4 shows a schematic diagram of a memory array including a plurality of the memory cells of figure 2;

Figure 5 shows a schematic timing diagram of the electric signals inside the memory cell of figure 3 during a write operation.

Detailed description

With reference to the above figures, a static random access memory cell according to the present invention is globally indicated with 10. The cell 10 is realized by a CMOS process.

The SRAM cell according to the present invention is specifically designed for a random access electronic memory device having a single bit line BL.

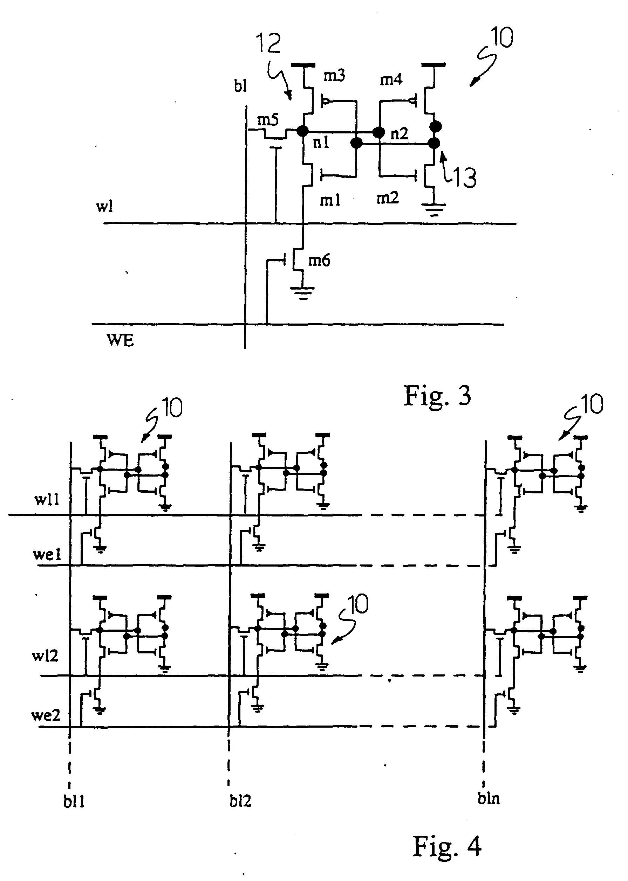

Each cell 10 is integrated in a memory array or matrix (partially shown in figure 4) including a plurality m of memory rows and a plurality n of memory columns.

The memory rows are identified as word lines WL of the memory device, while the memory columns are the bit lines BL of the memory device. Each cell 10 may be identified at the intersection between a word line WL and a single bit line BL.

The memory cell 10 comprises a couple of CMOS inverters 12 and 13 each including a pull-up PMOS transistor and a pull-down NMOS transistor. The two inverters 12, 13 are cross-coupled since the interconnection node between two transistors of one inverter is connected to the driving terminals of the other inverter.

The first inverter 12 comprises a PMOS transistor M3 and an NMOS transistor M1. The second inverter 13 comprises a PMOS transistor M4 and an NMOS transistor M2.

The transistors M1 and M3 of the first inverter 12 have their corresponding gate terminals connected to a first circuit internal node N1 which is connected to the drain common terminals of the other inverter 13.

The transistors M2 and M4 of the second inverter 13 have their corresponding gate terminals connected to a second circuit internal node N2 which is connected to the drain common terminals of the other inverter 12.

The source terminals of the PMOS transistors M3, M4 of the first and second inverters 12, 13 are both connected to a voltage supply line Vdd.

According to the present invention, the source terminal of the NMOS transistor M2 of the second inverter 13 is connected to a reference potential, for instance a ground GND.

On the contrary, the source terminal of the NMOS transistor M1 of the first inverter 12 is connected to ground via an extra transistor M6.

Therefore, according to the present invention the source of one of the pull-down or driver transistors, namely the transistor M1, instead of being grounded is connected to ground GND via the extra transistor M6.

The extra transistor M6 is a NMOS transistor having its gate terminal controlled by a signal "we". The signal we is present on a signal line WE which runs parallel to the word line and is common to all the cells 10 of each row.

Therefore, the gate terminal of each extra transistor M6 is connected to the signal line WE.

The structure of the memory cell is completed by an access transistor MS which connects the second circuit node N2 to the bit line.

This transistor M5, which may be a PMOS transistor, has the conduction terminals connected between the circuit node N2 and the corresponding bit line and the gate terminal connected to the word line WL.

Figure 4 shows a schematic diagram of the inside structure of the memory matrix including the plurality of cells 10 according to the present invention.

When the cell is not accessed, and during the reading phase, the signal line WE is tied high. This provides a ground to the driver transistor M1. So, data retention and read operation is performed in the conventional manner.

Now, let's consider the usual problem for these kind of cells of over-writing a low logic value with a high logic value.

It the first node N1 in figure 2 is low and there is the need of writing a high logic value into the cell, than the bit line BL is set high and the word line WL is turned on.

This leads the transistors M5 and M1 to fight one another. In order to make the cell stable during the read operation the prior art teaches to dimension the transistor M1 larger than the transistor M5. However, this makes writing quite difficult and requires special techniques as already mentioned when presenting the prior art problems.

According to the invention, the writing phase of the memory device is performed in four steps or phases which solve the prior art drawbacks:

1) a low going pulse is applied to the signal line WE. This pulse turns off any current flow in transistor M1. If the node N1 was at a high logic level, it remains tied to such logic level by transistor M3.
Otherwise, if the N1 was at a low logic level it becomes temporary floating low.
2) The desired data is placed on the bit lines.
3) The word line WL goes high and the bit line data is written into the memory cell without having to fight against transistor M1.
4) The signal line WE is turned off and disabled before, or simultaneously, with the word line WL. The memory cell 10 now latches to the new data.

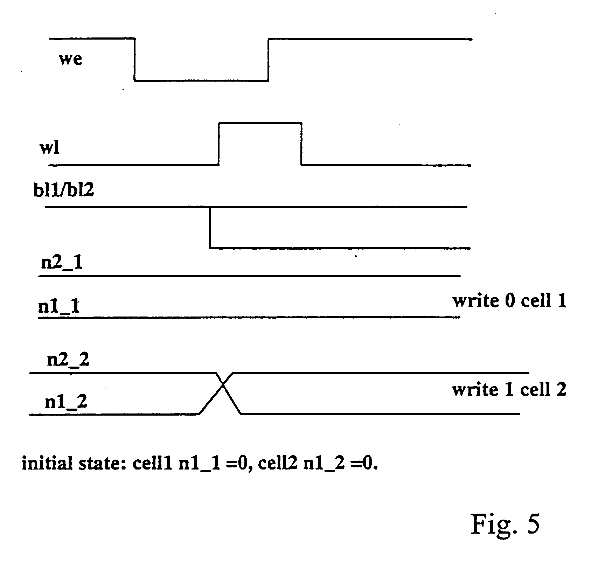

Figure 5 reports the timing diagrams of the whole write operation. These diagrams relate to the programming or write phase of a couple of memory cells.

The RAM memory cell according to the invention has the great advantage of allowing a reduction of the power consumption. Moreover, this is obtained by a simple writing operation technique.

This advantage is specifically evident for memory structures having a very long wordlenght.

## Claims

1. A RAM memory cell (10) with a single bit line for a memory matrix comprising a plurality of word-lines (WL) and bit-lines (BL), said cell (10) including a first and a second cross-coupled CMOS inverters (12, 13), each including a PMOS pull-up transistor (M3, M4) and an NMOS pull-down transistor (M1, M2), and an access transistor (M5) connecting one of the inverter (13) to the bit line (BL), characterized by comprising an extra transistor (M6) connecting the source terminal of one of the pull-down transistors (M1, M2) to a ground (GND).

2. A RAM memory cell according to claim 1, characterized in that said extra transistor (M6) is connected between the source terminal of the pulldown transistor (M1) of the first inverter (12) and said ground (GND).

3. A RAM memory cell according to claim 1, characterized in that the gate terminal of said extra transistor (M6) is connected to a signal line (WE) running parallel to the word line.

4. A RAM memory cell according to claim 3, characterized in that said signal line (WE) is an extra line which is common to all the cells (10) of a word line.

5. A RAM memory cell according to claim 1, characterized in that said extra transistor (M6) is an NMOS transistor.

6. A RAM memory cell according to claim 2, characterized in that the current flow in said pull-down transistor (M1) is turned off during the writing phase of the memory cell.

7. A RAM memory cell according to claim 1, wherein the cell is a static RAM.

Fig. 1

Fig. 2

Fig. 3

Fig. 4

initial state: cell1 n1_1 =0, cell2 n1_2 =0.

Fig. 5

European Patent Office

**EUROPEAN SEARCH REPORT**

Application Number

EP 97 12 0942

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 112 506 A (ZIBU MITUO) 5 September 1978 <br> * column 5, line 43 - column 8, line 5 * <br> * column 9, line 52 - column 10, line 19 * | 1,2,5-7 | G11C11/41 |
| A | * figures 2,3 * | 3,4 | |
| X | US 5 353 251 A (URATANI MUNEHIRO ET AL) 4 October 1994 | 1,2,5-7 | |
| A | * column 2, line 50 - column 5, line 28; figure 8 * | 3,4 | |
| A | DE 43 17 382 A (MITSUBISHI ELECTRIC CORP) 2 December 1993 <br> * column 4, line 24 - column 5, line 35 * <br> * column 7, line 46 - column 8, line 32 * <br> * figures 1,4,5 * | 1 | |
| A | PATENT ABSTRACTS OF JAPAN <br> vol. 009, no. 161 (P-370), 5 July 1985 <br> & JP 60 038796 A (HITACHI SEISAKUSHO KK), 28 February 1985, <br> * abstract * | 1 | TECHNICAL FIELDS SEARCHED (Int.Cl.6) <br><br> G11C |
| A | YUZURIHA K ET AL: "A NEW PROCESS TECHNOLOGY FOR A 4MBIT SRAM WITH POLYSILICON LOAD RESISTOR CELL" SYMPOSIUM ON VLSI TECHNOLOGY, KYOTO, MAY 22 - 25, 1989, <br> no. SYMP. 9, 22 May 1989, INSTITUTE OF ELECTRICAL AND ELECTRONICS ENGINEERS, page 61/62 XP000091371 <br> * page 61, column 2, line 10 - column 2, line 21; figure 6A * | 1 | |

The present search report has been drawn up for all claims

| Place of search | Date of completion of the search | Examiner |
|---|---|---|
| THE HAGUE | 12 May 1998 | Degraeve, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document